# EUROPEAN PATENT APPLICATION

(11) **EP 4 729 349 A1**
(43) Date of publication of application: **22.04.2026**
(21) Application number: 24852088.4
(22) Date of filing: 10.07.2024
(51) Int. Cl.: B60L 58/10, B60L 53/10, B60L 53/20, G01R 27/02, H02J 7/00

(54) **BATTERY MANAGEMENT SYSTEM, BATTERY DEVICE INCLUDING SAME, AND CHARGING CONTROL METHOD**

(30) Priority: 04.08.2023 KR 20230102320
(71) Applicant: LG Energy Solution, Ltd., Seoul 07335 (KR)
(72) Inventor: CHOI, Jang Hyeok, Daejeon 34122 (KR); KIM, Kyeongmin, Daejeon 34122 (KR)
(74) Representative: Plasseraud IP
(86) International application number: PCT/KR2024/009813
(87) International publication number: WO 2025/033732

(57) **Abstract**

The battery management system wakes up based on a first control signal provided by an AC charger or a DC charger in response to a connection between the vehicle and the AC charger or the DC charger, determines a connection state between the AC charger or the DC charger and the vehicle based on a voltage of a second control signal determined based on the connection between the AC charger and the vehicle, or a voltage of a third control signal determined based on the connection between the DC charger and the vehicle, and selects an AC charging mode or a DC charging mode based on the voltage of the second control signal and the voltage of the third control signal to perform charging.

## Description

### [Technical Field]

### CROSS-REFERENCE TO RELATED APPLICATION

This application claims priority to and the benefit of Korean Patent Application No. 10-2023-0102320 filed in the Korean Intellectual Property Office on August 4, 2023, the entire contents of which are incorporated herein by reference.

The disclosure relates to a battery management system, a battery apparatus including the same, and a charging control method.

### [Background Art]

Rechargeable batteries are being used as an energy source for vehicles. The battery is provided in the form of battery pack, and a battery management system (BMS) is used to manage the battery pack. Various chargers are used to charge the battery pack mounted in the vehicle. It is required that the battery management system managing the battery pack performs charge control of the various chargers instead of an electronic control unit (ECU) or on-board charger (OBC) of the vehicle.

### [Disclosure]

### [Technical Problem]

Some embodiments may provide a battery management system, a battery apparatus including the same, and a charge control method, for performing charge control of various chargers.

### [Technical Solution]

According to some embodiments, a battery apparatus configured to be mounted on a vehicle may include a battery module and a battery management system. The battery management system may be configured to wake up based on a first control signal provided by an alternate current (AC) charger or a direct current (DC) charger in response to a connection between the vehicle and the AC charger or the DC charger, determine a connection state between the AC charger or the DC charger and the vehicle based on a voltage of a second control signal determined based on the connection between the AC charger and the vehicle, or a voltage of a third control signal determined based on the connection between the DC charger and the vehicle, and select an AC charging mode or a DC charging mode based on the voltage of the second control signal and the voltage of the third control signal to perform charging.

According to some embodiments, a battery management system of a battery apparatus configured to be mounted on a vehicle may include a connector, a first control circuit and a processor. The connector may be configured to be connected to an AC charger or a DC charger, and receive a first control signal provided by the AC charger or the DC charger in response to a connection of the AC charger or the DC charger. The first control circuit may be connected to the connector, and may be configured to determine a voltage of a second control signal based on a connection between the AC charger and the vehicle, and determine a voltage of a third control signal based on a connection between the DC charger and the vehicle. The processor may be configured to wake up the battery management system in response to the first control signal from the connector, determine a connection state between the AC charger or the DC charger and the vehicle based on the voltage of the second control signal or the voltage of the third control signal, and select an AC charging mode or a DC charging mode based on the voltage of the second control signal and the voltage of the third control signal to perform charging.

According to some embodiments, a method of controlling charging in a battery management system may include receiving a predetermined voltage in response to a connection between a vehicle equipped with the battery management system and a charger, waking up in response to the predetermined voltage, selecting an AC charging mode or a DC charging mode based on a voltage of a control signal determined based on the connection between the charger and the vehicle, and determining a connection state between the charger and the vehicle based on a voltage of the control signal.

### [Description of the Drawings]

FIG. 1 is a diagram illustrating an example of a charging system according to an embodiment.
FIG. 2 is a diagram illustrating an example of a battery apparatus according to an embodiment.
FIG. 3 is a diagram illustrating an example of a battery management system according to an embodiment.
FIG. 4 is a flowchart illustrating an example of an AC charge control method in a battery management system according to an embodiment.
FIG. 5 is a flowchart illustrating an example of a DC charge control method in a battery management system according to an embodiment.
FIG. 6 is a diagram illustrating an example of operational timing for AC charging of a battery management system according to an embodiment.
FIG. 7 is a diagram illustrating an example of operational timing for DC charging of a battery management system according to an embodiment.
FIG. 8 is a diagram illustrating an example of a battery apparatus according to an embodiment.
FIG. 9 and FIG. 10 are each diagrams illustrating an example of insulation resistance measurement in a battery apparatus according to an embodiment.

### [Mode for Invention]

In the following detailed description, only certain embodiments of the present invention have been shown and described, simply by way of illustration. As those skilled in the art would realize, the described embodiments may be modified in various different ways, all without departing from the spirit or scope of the present invention. Accordingly, the drawings and description are to be regarded as illustrative in nature and not restrictive. Like reference numerals designate like elements throughout the specification.

When it is described that an element is "connected" to another element, it should be understood that the element may be directly connected to the other element or connected to the other element through a third element. On the other hand, when it is described that an element is "directly connected" to another element, it should be understood that the element is connected to the other element through no third element.

As used herein, a singular form may be intended to include a plural form as well, unless the explicit expression such as "one" or "single" is used.

In flowcharts described with reference to the drawings, the order of operations or steps may be changed, several operations or steps may be merged, a certain operation or step may be divided, and a specific operation or step may not be performed.

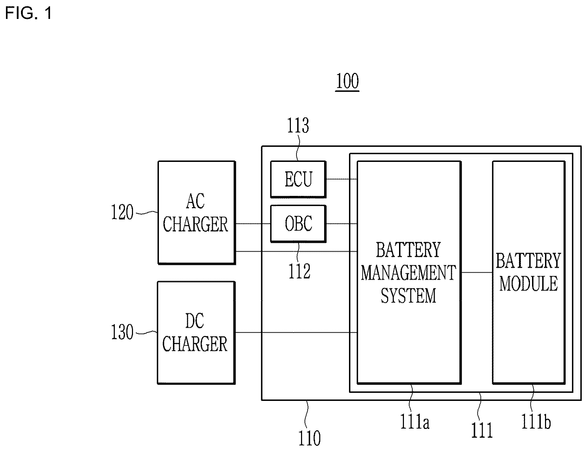

FIG. 1 is a diagram illustrating an example of a charging system according to an embodiment.

Referring to FIG. 1, a charging system 100 may include a vehicle 110, an alternating current (AC) charger 120, and a direct current (DC) charger 130.

The AC charger 120 may supply AC power to the vehicle 110 to charge a battery module 111b of the vehicle 110. The DC charger 130 may supply DC power to the vehicle 110 to charge the battery module 111b of the vehicle 110. In some embodiments, the AC charger 120 may include a control device to control AC charging. In some embodiments, the DC charger 130 may include an off-board charger that controls DC charging, and the off-board charger may include an AC-DC converter that converts AC power to DC power to provide the DC power and a DC-DC converter that converts DC power to DC power.

The vehicle 110 may include a battery apparatus 111 and an on-board charger (OBC) 112. The battery apparatus 111 may be called a battery pack. The battery apparatus 111 may include the battery module 111b and a battery management system 111a that manages operations of the battery module 111b. The battery module 111b may include a plurality of battery cells. The battery cells may be rechargeable battery cells. In some embodiments, the battery apparatus 111 may include a plurality of battery modules 111b connected in series and/or parallel. The battery module 111b may be called a battery pack that does not include the battery management system 111a. The vehicle 110 may further include an electronic control unit (ECU) 113 that controls one or more electrical systems, including the battery management system 111a, in the vehicle 110.

When the vehicle 110 is connected to the AC charger 120 for charging, the AC charger 120 may provide AC power to the vehicle 110. The OBC 112 may include an AC/DC converter that converts the AC power supplied by the AC charger 120 to DC power. The battery management system of the battery apparatus 111 may use the DC power transferred through the OBC 112 to control charging of the battery module 111b.

When the vehicle 110 is connected to the DC charger 130 for charging, the DC charger 130 may supply DC power to the vehicle 110. The battery management system 111a of the battery apparatus 111 may use the DC power supplied by the DC charger 130 to control charging of the battery module 111b.

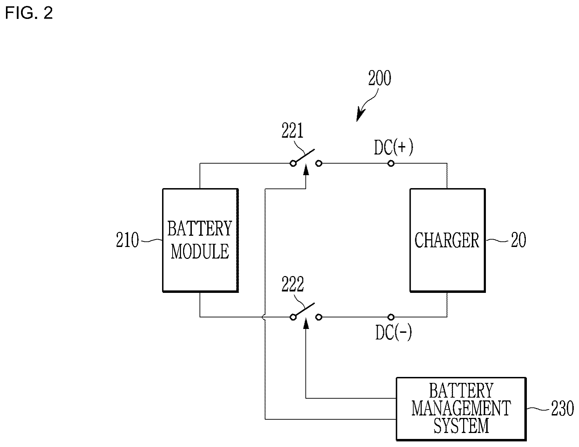

FIG. 2 is a diagram illustrating an example of a battery apparatus according to an embodiment.

Referring to FIG. 2, the battery apparatus 200 may include a battery module 210, a positive switch 221, a negative switch 222, and a battery management system 230.

The battery modules 210 may include a plurality of battery cells. In some embodiments, the battery apparatus 200 may include a plurality of battery modules 210 connected in series and/or parallel.

The positive switch 221 may be connected between a positive terminal of the battery module 210 and a positive link terminal DC(+) of the battery apparatus 200, and the negative switch 222 may be connected between a negative terminal of the battery module 210 and a negative link terminal DC(-) of the battery apparatus 200. The switches 221 and 222 may be charge-control switches that are controlled by the battery management system 230 to control a charging path between the battery module 210 and a charger 20. When the battery apparatus 200 is charged, the positive link terminal DC(+) and the negative link terminal DC(-) may be connected to the charger 20. When the positive switch 221 and the negative switch 222 are closed by control of the battery management system 230, power (e.g., charging current) may be supplied from the charger 20 to the battery module 210 to charge the battery module 210. The closing of the switch may be expressed as "on" of the switch, and opening of the switch may be expressed as "off" of the switch. In some embodiments, the switches 221 and 222 may each be formed as a relay.

In some embodiments, the charger 20 may be connected to the battery module 210 without using the link terminals DC(+) and DC(-) and the switches 221 and 222 of the battery apparatus 200. In this case, the charging path between the battery module 210 and the charger 20 may be controlled by control of charge-control switches on the charger 20.

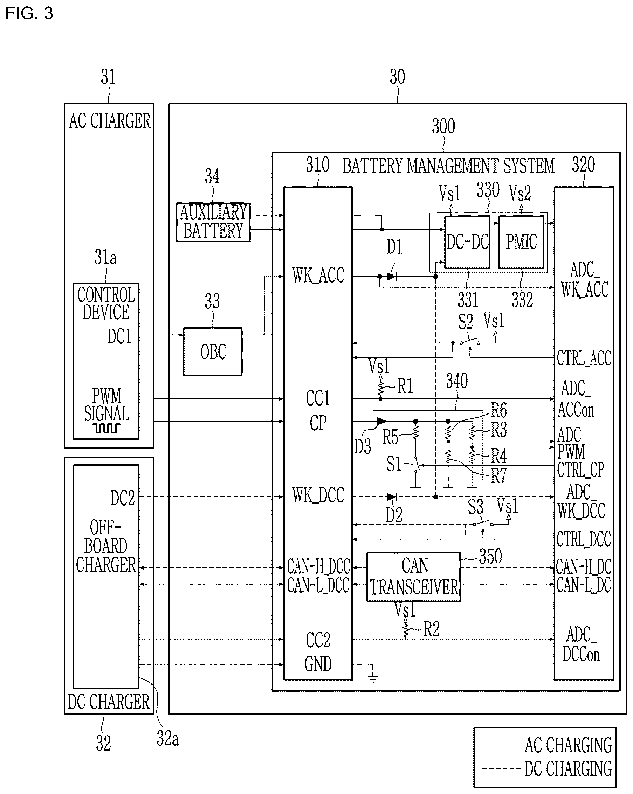

FIG. 3 is a diagram illustrating an example of a battery management system according to an embodiment.

Referring to FIG. 3, a battery management system 300 may include a connector 310 and a processor 320. The battery management system 300 may support AC charging when an AC charger 31 is connected to a vehicle 30 equipped with a battery apparatus, and support DC charging when a DC charger 32 is connected to the vehicle 30.

The connector 310 may be used to connect the AC charger 31 to the battery management system 300 and the DC charger 32 to the battery management system 300. In some embodiments, the connector 310 may be connected to an OBC 33 mounted on the vehicle 30 for AC charging of the AC charger 31. The processor 320 may control the AC charging when the AC charger 31 is connected to the vehicle 30, and may control DC charging when the DC charger 32 is connected to the vehicle 30. In some embodiments, the processor 320 may be processing circuitry, for example, a microcontroller unit (MCU).

In some embodiments, when the AC charger 31 is connected to the vehicle 30, a control signal DC1 having a predetermined voltage may be received from a control device 31a of the AC charger 31. The connector 310 may provide a wakeup signal WK_ACC corresponding to the control signal DC1 to the processor 320. In some embodiments, the control signal DC1 from the AC charger 31 may be transferred to the OBC 33, and the OBC 33 may transfer the control signal DC1 or a signal corresponding to the control signal DC1 to the connector 310. In some embodiments, the battery management system 300 may further include an analog-to-digital converter, and the wake-up signal WK_ACC transferred from the connector 310 may be converted to a digital signal ADC_WK_ACC by the analog-to-digital converter and provided to the processor 320. The processor 320 may wake up in response to the wake-up signal ADC_WK_ACC, and then wake up the battery management system 300.

In some embodiments, when the DC charger 32 is connected to the vehicle 30, the connector 310 may receive a control signal DC2 having a predetermined voltage from an off-board charger 32a of the DC charger 32. The connector 310 may provide a wake-up signal WK_DCC corresponding to the control signal DC2 to the processor 320. In some embodiments, the wake-up signal WK_DCC transferred from the connector 310 may be converted to a digital signal ADC_WK_DCC by an analog-to-digital converter and provided to the processor 320. The processor 320 may wake up in response to the wake-up signal ADC_WK_DCC, and then wake up the battery management system 300.

In some embodiments, the battery management system 300 may further include a voltage supply circuit 330. The voltage supply circuit 330 may supply various operating voltages used by the battery management system 300. In some embodiments, the voltage supply circuit 330 may supply a first operating voltage Vs1 (e.g., 12 V) used for an internal circuitry of the battery management system 300 and a second operating voltage Vs2 (e.g., 5 V) used for an operation of the processor 320. In some embodiments, the voltage supply circuit 330 may include a DC-DC converter 331 and a power management circuit (e.g., a power management integrated circuit (PMIC) 332). The DC-DC converter 331 may include, for example, a buck converter, and the PMIC 332 may include a regulator, for example, a low-dropout regulator (LDO).

The DC-DC converter 331 may receive an auxiliary voltage from an auxiliary battery 34 of the vehicle 30 via the connector 310 and generate the first operating voltage Vs1 based on the auxiliary voltage. The PMIC 332 may receive the first operating voltage Vs1 and generate the second operating voltage Vs2 that is lower than the first operating voltage Vs1 based on the first operating voltage Vs1. In some embodiments, the wake-up signals WK_ACC and WK_DCC may be provided to the voltage supply circuit 330 to enable the voltage supply circuit 330, such as the DC-DC converter 331. In some embodiments, a diode D1 for blocking current in an opposite direction may be connected between a wake-up signal (WK_ACC) output port of the connector 310 and an enable port of the voltage supply circuit 330, such as the DC-DC converter 331, and a diode D2 for blocking current in an opposite direction may be connected between a wake-up signal (WK_DCC) output port of the connector 310 and the enable port of the voltage supply circuit 330, such as the DC-DC converter 331.

In some embodiments, the connector 310 may receive a control signal CC1 for connection confirmation from the control device 31a of the AC charger 31. Such a control signal CC1 may be referred to as a connection confirm (CC) signal CC1. The CC signal CC1 may be determined based on a connection between the AC charger 31 and the vehicle 30. In some embodiments, the CC signal CC1 may be determined based on a resistor (not shown) used to transfer the CC signal CC1 in the control device 31a of the AC charger 31 and a resistor R1 of the battery management system 300. The resistor used to transfer the CC signal CC1 in the control device 31a may be determined based on a connection state between the vehicle 30 and the AC charger 31. The resistor R1 may be connected between a line for supplying the first operating voltage Vs1 and a CC signal (CC1) output port of the connector 310. Thus, a voltage into which the first operating voltage Vs1 is divided by the resistor of the control device 31a and the resistor R1 of the battery management system 300 may be determined to be the CC signal CC1. The processor 320 may determine the connection state (e.g., whether to be fully connected) between the AC charger 31 and the vehicle 30 based on the voltage of the CC signal CC1. In some embodiments, an analog-to-digital converter in the battery management system 300 may convert the CC signal CC1 to a digital signal ADC_ACCon and transfer it to the processor 320.

In some embodiments, the connector 310 may receive a control signal CC2 for connection confirmation from the off-board charger 32a of the DC charger 32. Such a control signal CC2 may be referred to as a connection confirmation (CC) signal CC2. The CC signal CC2 may be determined based on a connection between the DC charger 32 and the vehicle 30. In some embodiments, the CC signal CC2 may be determined by a resistor (not shown) used to transfer the CC signal CC2 in the off-board charger 32a of the DC charger 32 and a resistor R2 of the battery management system 300. The resistor used to transfer the CC signal CC2 in the off-board charger 32a may be determined based on a connection state between the vehicle 30 and the DC charger 32. The resistor R2 may be connected between the line for supplying the first operating voltage Vs1 and a CC signal (CC2) output port of the connector 310. Thus, a voltage into which the first operating voltage Vs1 is divided by the resistor of the off-board charger 32a and the resistor R2 of the battery management system 300 may be determined to be the CC signal CC2. The processor 320 may determine the connection state (e.g., whether to be fully connected) between the DC charger 32 and the vehicle 30 based on the voltage of the CC signal CC2. In some embodiments, an analog-to-digital converter in the battery management system 300 may convert the CC signal CC2 to a digital signal ADC_DCCon and transfer it to the processor 320.

In some embodiments, a control circuit including the resistors R1 and R2 may be referred to as a connection confirm circuit. The connection confirm circuit may be connected to the connector 310. The connection confirm circuit may determine a voltage of the CC signal CC1 based on the connection between the AC charger 31 and the vehicle 30, and determine a voltage of the CC signal CC2 based on the connection between the DC charger 32 and the vehicle 30.

In some embodiments, the connector 310 may receive a pulse width modulation (PWM) signal from the AC charger 31 as a control signal, and transfer the PWM signal to the processor 320. The PWM signal may be called a control pilot (CP) signal. In some embodiments, an analog-to-digital converter of the battery management system 300 may convert the PWM signal to a digital signal and provide it to the processor 320. The processor 320 may determine whether the AC charger 31 is ready to charge by measuring the PWM signal.

In some embodiments, the battery management system 300 may further include a PWM control circuit 340. The PWM control circuit 340 may be referred to as a "control pilot circuit." The PWM control circuit 340 may transfer the PWM signal received from the AC charger 31 via the connector 310 to the processor 320, and may reduce a voltage level of the PWM signal during AC charging and transfer it to the processor 320.

In some embodiments, the PWM control circuit 340 may include resistors R3 and R4 that are connected in series between a PWM signal output port of the connector 310 and a ground terminal, and a resistor R5 and a switch S1 that are connected in series between the PWM signal output port and the ground terminal. In some embodiments, the PWM control circuit 340 may further include a diode D3 for blocking current to the PWM signal output port. Prior to the AC charging, the switch S1 may be turned off so that a voltage divided by the resistors R3 and R4 and the resistor of the AC charger 31 may be provided to the processor 320 as the PWM signal. The processor 320 may determine a duty cycle and/or frequency of the PWM signal based on the PWM signal output at a contact of the resistors R3 and R4. During the AC charging, the switch S1 may be turned on in response to a control signal CTRL_CP from the processor 320, so that the PWM signal having a voltage level lower than a voltage level prior to the AC charging may be provided to the processor 320. In some embodiments, the PWM control circuit 340 may further include resistors R6 and R7 connected in series between the PWM signal output port of the connector 310 and the ground terminal. A voltage divided by the resistors R6 and R7 and the resistor of the AC charger 31 may be provided to the processor 320 as the PWM signal. The processor 320 may determine a voltage level of the PWM signal based on a voltage ADC into which the PWM signal output from a contact of the resistors R6 and R7 is converted by the analog-to-digital converter.

In some embodiments, when the AC charger 31 is ready to charge, the processor 320 may output a control signal CTRL_ACC to turn on a charge-control switch that controls a charging path between a battery module (e.g., 210 in FIG. 2) of a battery apparatus and a terminal for transferring charging current from the control device 31a of the AC charger 31. In some embodiments, the switch S2 may be turned on in response to the control signal CTRL_ACC so that a control signal having a first operating voltage Vs1 may be transferred to the charge-control switch via the connector 310. Further, when the DC charger 32 is ready to charge, the processor 320 may output a control signal CTRL_DCC to turn on the charge-control switch to control a charging path between the battery module 210 of the battery apparatus and a terminal for transferring charging current from the off-board charger 32a of the DC charger 32. In some embodiments, the switch S3 may be turned on in response to the control signal CTRL_DCC so that a control signal having the first operating voltage Vs1 may be transferred to the charge-control switch via the connector 310.

In some embodiments, the battery management system 300 may further include a transceiver 350. In some embodiments, the transceiver 350 may be a controller area network (CAN) transceiver for CAN communication. The processor 320 may communicate with the off-board charger 32a of the DC charger 32 via the transceiver 350 and the connector 310. For example, the processor 320 may communicate with the connector 310 via the transceiver 350 using differential CAN signals CAN-H_DC and CAN-L_DC, and the connector 310 may communicate with the off-board charger 32a of the DC charger 32 using differential CAN signals CAN-H_DCC and CAN-L_DCC.

In some embodiments, the off-board charger 32a of the DC charger 32 may be grounded (GND) via the connector 310.

As described above, the battery management system 300 may wake up based on the control signal DC1 or DC2 provided by the charger in response to the connection between the vehicle 30 and the charger 31 or 32, determine the full connection between the charger 31 or 32 and the vehicle 30 based on the voltage of the control signal CC1 determined based on the connection between the AC charger 31 and the vehicle 30 or the voltage of the control signal CC2 determined based on the connection between the DC charger 32 and the vehicle 30, and select an AC charging mode or a DC charging mode based on the voltage of the control signal CC1 and the voltage of the control signal CC2 to proceed with charging. As such, the battery management system 300 may selectively support AC charging and DC charging depending on the type of charger connected to the vehicle 30.

Referring to FIGS. 3 to 5, a method of controlling AC charging and DC charging in a battery management system is described.

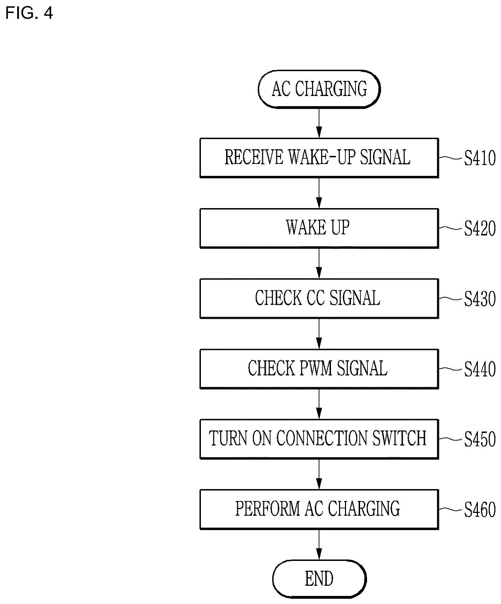

FIG. 4 is a flowchart illustrating an example of an AC charge control method in a battery management system according to an embodiment.

Referring to FIGS. 3 and 4, when a AC charger 31 is connected to a vehicle 30, a battery management system 300 may perform AC charging. When the AC charger 31 is connected to the vehicle 30, a processor 320 of the battery management system 300 may perform a wakeup of the battery management system 300 in response to a connection between the AC charger 31 and the vehicle 30 (S410 and S420).

In some embodiments, when the AC charger 31 is connected to the vehicle 30, the vehicle may detect a predetermined voltage. In some embodiments, when the AC charger 31 is connected to the vehicle 30, an OBC 33 may send a wake-up signal WK_ACC corresponding to a predetermined signal DC1 to the processor 320 of the battery management system 300 via the connector 310 in response to the predetermined signal DC1 from the AC charger 31 (S410). In some other embodiments, when the AC charger 31 is connected to the vehicle 30, the processor 320 may receive the predetermined signal DC1 from the AC charger 31 as a wake-up signal WK_ACC via the connector 310 (S410). In some embodiments, the predetermined signal DC1 may correspond to the predetermined voltage, for example, 12 V, that is transferred when the AC charger 31 is connected to the vehicle 30. In some embodiments, an analog-to-digital converter of the battery management system 300 may convert the wake-up signal WK_ACC output from the connector 310 to a digital wake-up signal ADC_WK_ACC and transfer it to the processor 320. The processor 320 may wake up the battery management system 300 in response to the wake-up signal ADC_WK_ACC (S420).

In some embodiments, the wake-up signal WK_ACC may be transferred to a voltage supply circuit 330 to enable the voltage supply circuit 330, for example, a DC-DC converter 331. Accordingly, operating voltages Vs1 and Vs2 may be supplied from the voltage supply circuit 330 to internal circuitry of the battery management system 300.

Next, the processor 320 may determine a connection state between the AC charger 31 and the vehicle 30 based on a CC signal CC1 (S430). In some embodiments, when the AC charger 31 is not connected to the vehicle 30, a port for transferring the CC signal CC1 in the connector 310 is in a floating state, so that the CC signal CC1 may have the first operating voltage Vs1 (e.g., 12 V) supplied from the voltage supply circuit 330. If the AC charger 31 is not fully connected (or is semi-connected) to the vehicle 30, a voltage (e.g., 9 volts) into which the first operating voltage Vs1 is divided by a resistor R1 and a resistance due to the semi-connection of the AC charger 31 may be output as the CC signal CC1. When the AC charger 31 is fully connected to the vehicle 30, a voltage (e.g., 3 V) into which the first operating voltage Vs1 is divided by the resistor R1 and a resistance of the AC charger 31 may be output as the CC signal CC1. Thus, the processor 320 may determine whether the AC charger 31 is fully connected to the vehicle 30 based on the voltage of the CC signal CC1 (S430). In some embodiments, an analog-to-digital converter of the battery management system 300 may convert the CC signal CC1 to a digital signal ADC_ACCon and transfer it to the processor 320. In some embodiments, the processor 320 may determine that the AC charger 31 is connected to the vehicle 30 when the voltage of the CC signal CC1 decreases from the first operating voltage Vs1, and may perform a procedure for AC charging.

When the AC charger 31 is fully connected to the vehicle 30, the processor 320 may receive a PWM signal from the AC charger 31 as a control pilot signal CP, and may check the PWM signal (S440). In some embodiments, the processor 320 may determine whether the AC charger 31 is ready to charge by measuring the PWM signal (S440). In some embodiments, if the AC charger 31 is not ready to charge, the AC charger 31 does not output the PWM signal, so the processor 320 may determine whether the AC charger 31 is ready to charge by measuring whether the PWM signal is output from the AC charger 31. In some embodiments, the processor 320 may determine a duty cycle and/or frequency of the PWM signal based on the PWM signal output at a contact of resistors R3 and R4 of a PWM control circuit 340. In some embodiments, the processor 320 may determine a voltage level of the PWM signal based on the PWM signal output at a contact of resistors R6 and R7 of the PWM control circuit 340.

When the AC charger 31 is ready, the processor 320 may turn on a charge-control switch that controls a charging path between a battery module (e.g., 210 in FIG. 2) of a battery apparatus and a terminal for transferring charging current from a control device 31a of the AC charger 31 (S450). In some embodiments, the charge-control switch may be implemented as a relay. In some embodiments, the charge-control switch may include switches (e.g., 221 and 222 in FIG. 2) that control the connection between the battery module (e.g., 210 in FIG. 2) of the battery apparatus and link terminals (e.g., DC(+) and DC(-) in FIG. 2) of the battery apparatus. In some embodiments, the processor 320 may turn on the charge-control switch by outputting a control signal CTRL_ACC having a predetermined level. In some embodiments, the processor 320 may perform a wake-up of the vehicle prior to turning on the charge-control switch (S450). Upon turning on the charge-control switch, the battery apparatus may perform AC charging (S460). Upon turning on the charge-control switch, charging current from the AC charger 31 may be supplied to the battery module 210 to charge the battery module 210.

In some embodiments, the processor 320 may provide a control signal CTRL_CP to the PWM control circuit 340 to turn on the switch S1 for AC charging. The PWM signal having a lower voltage level than the PWM signal provided as the control pilot signal prior to AC charging may then be provided to the processor 320.

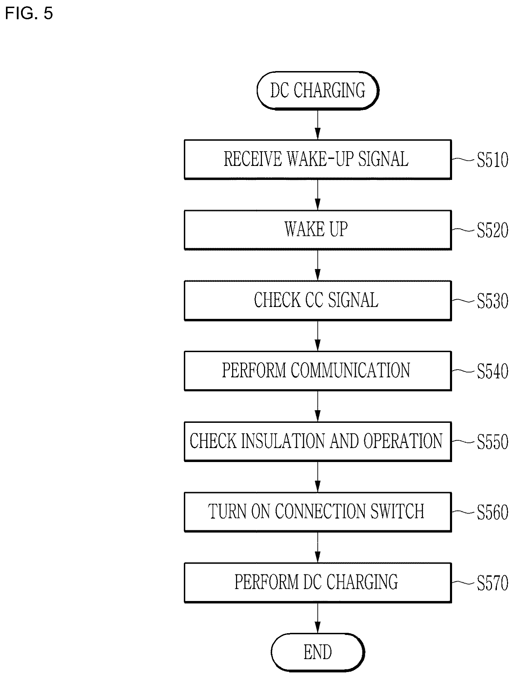

FIG. 5 is a flowchart illustrating an example of a DC charge control method in a battery management system according to an embodiment.

Referring to FIGS. 3 and 5, in some embodiments, when a DC charger 32 is connected to a vehicle 30, a battery management system 300 may perform DC charging. When the DC charger 32 is connected to the vehicle 30, a processor 320 of the battery management system 300 may perform a wake-up of the battery management system 300 in response to a connection between the DC charger 32 and the vehicle 30 (S510 and S520).

In some embodiments, when the DC charger 32 is connected to the vehicle 30, a predetermined signal DC2 from the DC charger 32 may be sent to the processor 320 of the battery management system 300 via a connector 310 as a wake-up signal WK_DCC (S510). In some embodiments, the predetermined signal DC2 may correspond to a predetermined voltage, for example, 12 V, that is transferred when the DC charger 32 is connected to the vehicle 30. In some embodiments, an analog-to-digital converter of the battery management system 300 may convert the wake-up signal WK_DCC output from the connector 310 to a digital wake-up signal ADC_WK_DCC and transfer it to the processor 320. The processor 320 may wake up the battery management system 300 in response to the wake-up signal ADC_WK_DCC (S520). In some embodiments, the wake-up signal WK_DCC may be transferred to a voltage supply circuit 330 to enable the voltage supply circuit 330, for example, a DC-DC converter 331.

Next, the processor 320 may determine a connection state between the DC charger 32 and the vehicle 30 based on a CC signal CC2 (S530). In some embodiments, when the DC charger 32 is not connected to the vehicle 30, a port for transferring the CC signal CC2 in the connector 310 is in a floating state, so that the CC signal CC2 may have a first operating voltage (e.g., 12 V) supplied from the voltage supply circuit 330. If the DC charger 32 is not fully connected to the vehicle 30, a voltage (e.g., 9 V) into which the first operating voltage Vs1 is divided by a resistor R2 and a resistance due to the semi-connection of the DC charger 32 may be output as the CC signal CC2. When the DC charger 32 is fully connected to the vehicle 30, a voltage (e.g., 3 V) into which the first operating voltage Vs1 is divided by the resistor R2 and a resistance of the DC charger 32 may be output as the CC signal CC2. Thus, the processor 320 may determine whether the DC charger 32 is fully connected to the vehicle 30 based on the voltage of the CC signal CC2 (S530). In some embodiments, an analog-to-digital converter of the battery management system 300 may convert the CC signal CC2 to a digital signal ADC_DCCon and transfer it to the processor 320. In some embodiments, the processor 320 may determine that the DC charger 32 is connected to the vehicle 30 when the voltage of the CC signal CC2 decreases from the first operating voltage Vs1, and may perform a procedure for DC charging.

Further, the processor 320 may communicate with the DC charger 32 (S540). In some embodiments, the processor 320 may communicate with the DC charger 32 to determine whether the DC charger 32 is ready to charge (S540). In some embodiments, the battery management system 300 may further include a transceiver 350, and the processor 320 may communicate with the DC charger 32 via the transceiver 350 and the connector 310.

Furthermore, the processor 320 may check an insulation state (e.g., a state of an insulation resistor) of the battery apparatus (S550). In some embodiments, the processor 320 may also check whether there is a fault in an operation defined for DC charging in the battery management system 300 (S550). In some embodiments, checking the insulation state and whether there is the fault in the operation may also be performed on AC charging.

After the battery apparatus is checked, the processor 320 may turn on a charge-control switch that controls a charging path between a battery module (e.g., 210 in FIG. 2) of the battery apparatus and a terminal for transferring charging current from an off-board charger 32a of the DC charger 32 (S560). In some embodiments, the charge-control switch may be implemented as a relay. In some embodiments, the charge-control switch may include a switch that controls a connection between the off-board charger 32a of the DC charger 32 and an external link terminal of the DC charger 32. In some embodiments, the charge-control switch may include switches (e.g., 221 and 222 in FIG. 2) that control connections between the battery module 210 of the battery apparatus and link terminals (e.g., DC(+) and DC(-) in FIG. 2) of the battery apparatus. In some embodiments, the processor 320 may turn on the charge-control switch by outputting a control signal CTRL_DCC having a predetermined level. In some embodiments, the battery management system 300 may provide a control signal for turning on the charge-control switch to the DC charger 32 via the connector 310.

In response to turn-on of the switch, the battery apparatus may perform DC charging (S570). In response to turn-on of the switch, charging current from the DC charger 32 may be supplied to the battery module 210 to charge the battery module 210.

As described above, the battery management system 300 may wake up based on the control signal (or a first control signal) DC1 or DC2 provided by the AC charger 31 or DC charger 32 in response to the connection between the vehicle 30 and the AC charger 31 or DC charger 32. Further, the battery management system 300 may determine the connection state between the AC charger 31 or DC charger 32 and the vehicle 30 based on the voltage of the control signal (or a second control signal) CC1 determined based on the connection between the AC charger 31 and the vehicle 30, or the voltage of the control signal (or a third control signal) CC2 determined based on the connection between the DC charger 32 and the vehicle 30, and perform charging by selecting an AC charging mode or a DC charging mode based on the voltage of the control signal CC1 and the voltage of the control signal CC2.

In some embodiments, the control signal CC1 may change from a first voltage (e.g., 12 V) to a second voltage (e.g., 9 V) when the vehicle 30 and the AC charger 31 are not fully connected, and may change from the second voltage (e.g., 9 V) to a third voltage (e.g., 3 V) when the vehicle 30 and the AC charger 31 are fully connected. Further, the control signal CC2 may maintain the first voltage while the AC charger 31 is connected to the vehicle 30. Thus, the battery management system 300 may determine that the AC charger 31 is connected and select the AC charging mode, based on the voltage of the control signal CC1 and the voltage of the control signal CC2.

In some embodiments, the control signal CC2 may change from the first voltage (e.g., 12 V) to the second voltage (e.g., 9 V) when the vehicle 30 and the DC charger 32 are not fully connected, and may change from the second voltage (e.g., 9 V) to the third voltage (e.g., 3 V) when the vehicle 30 and the DC charger 32 are fully connected. Further, the control signal CC1 may maintain the first voltage while the DC charger 32 is connected to the vehicle 30. Thus, the battery management system 300 may determine that the DC charger 31 is connected and select the DC charging mode, based on the voltage of the control signal CC1 and the voltage of the control signal CC2.

In some embodiments, the charging control method of the battery management system 300 may include receiving a predetermined voltage DC1 or DC2 in response to a connection between the vehicle 30 and the charger 31 or 32, waking up in response to the predetermined voltage, selecting either an AC charging mode or a DC charging mode based on a voltage of a control signal CC1 and/or CC2 determined based on the connection between the charger 31 or 32 and the vehicle 30, and determining a connection state between the charger 31 or 32 and the vehicle 30 based on the voltage of the control signal CC1 and/or CC2.

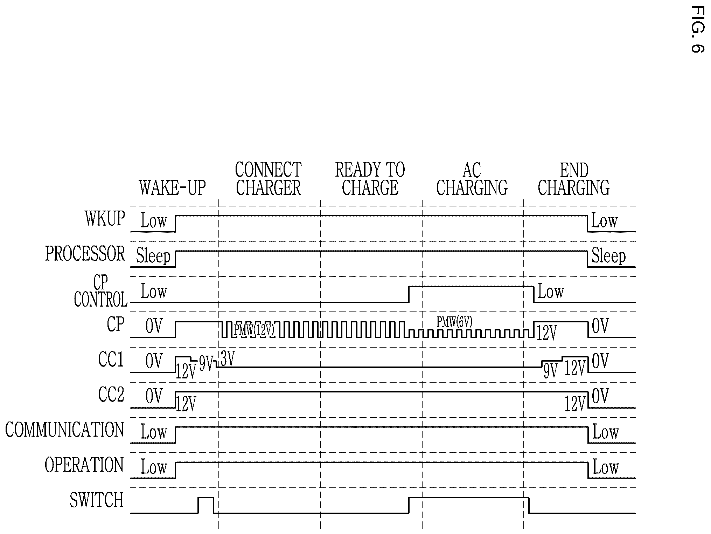

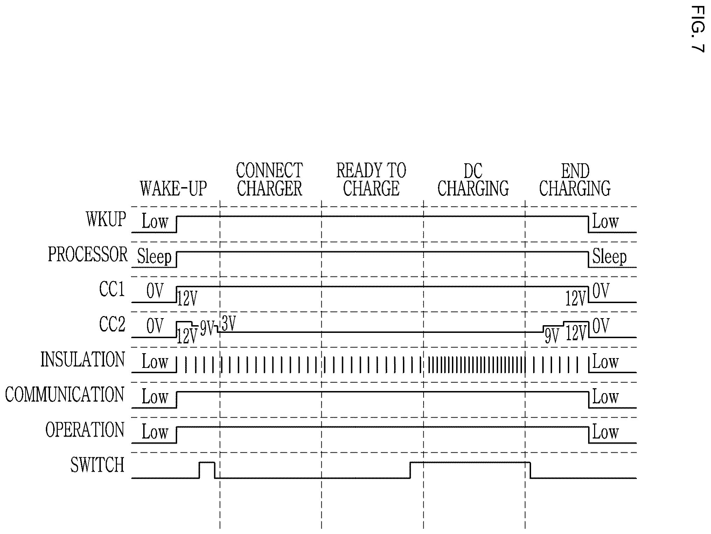

FIG. 6 is a diagram illustrating an example of operational timing for AC charging of a battery management system according to an embodiment, and FIG. 7 is a diagram illustrating an example of operational timing for DC charging of a battery management system according to an embodiment.

Referring to FIG. 6, when an AC charger is connected to a vehicle, a wake-up signal WKUP sent to a processor of a battery management system may be changed to a predetermined voltage (e.g., a high level). Accordingly, the battery management system may wake up from a sleep state. In some embodiments, the processor may check whether a charge-control switch is operating normally for charging. For example, the processor may temporarily turn on the charge-control switch. As an operating voltage is supplied by the wake-up of the battery management system, CC signals CC1 and CC2 and a control pilot signal CP provided to the processor may also change to an operating voltage (e.g., 12 V). In response to a connection between the AC charger and the vehicle, the CC signal CC1 may change from the operating voltage (e.g., 12V) to a first predetermined voltage (e.g., 9V) lower than the operating voltage. As the AC charger and the vehicle are fully connected, the CC signal CC1 may change from the first predetermined voltage (e.g., 9V) to a second predetermined voltage (e.g., 3V) lower than the first predetermined voltage.

By detecting the voltage of the CC signal CC1 as the second predetermined voltage, the processor may determine that the AC charger and the vehicle are fully connected. In this case, since the AC charger is connected, a CC signal CC2 for a DC charger may maintain the operating voltage 12V. Therefore, the processor may determine to proceed with an AC charging mode among the AC charging mode and the DC charging mode based on the voltages of the CC signals CC1 and CC2. Further, as the AC charger and the vehicle are fully connected, a PWM signal may be provided from the AC charger to the processor of the battery management system as a CP signal. The CP signal may have a voltage level, for example, an operating voltage (12 V). The processor may determine that the AC charging is ready by measuring the CP signal. In some embodiments, the processor may check a communication state between the AC charger and the battery management system and/or whether there is a fault in an operation defined for charging before performing AC charging.

The processor may turn on a charge-control switch for AC charging to supply charging current from the AC charger to a battery module of a battery apparatus. In some embodiments, the processor may provide a CP control signal (PWM control signal) having a predetermined voltage (e.g., a high level) to a PWM control circuit to decrease the voltage level of the CP signal provided by the AC charger (e.g., the voltage level of the CP signal may be decreased to 6 V).

The processor may end the charging procedure after completing the AC charging. To end the charging procedure, the processor may turn off the charge-control switch. In some embodiments, the processor may increase the voltage level of the CP signal by blocking the CP control signal (e.g., changing the CP control signal to a low level). As the AC charging is completed, the AC charger may be disconnected from the vehicle so that the CC signal CC1 may increase from 3 V to 9 V and then from 9 V to 12 V. As the AC charger is fully disconnected, the battery management system enters a sleep state, and the CC signals CC1 and CC2 and the CP signal may change to 0 V.

Referring to FIG. 7, when a DC charger is connected to a vehicle, a wake-up signal WKUP sent to a processor of a battery management system may be changed to a predetermined voltage (e.g., high level). Accordingly, the battery management system may wake up from a sleep state. In some embodiments, the processor may check whether a charge-control switch is operating normally for charging. For example, the processor may temporarily turn on the charge-control switch. As an operating voltage is supplied by the wake-up of the battery management system, CC signals CC1 and CC2 provided to the processor may also change to an operating voltage (e.g., 12 V). In response to a connection between the DC charger and the vehicle, the CC signal CC2 may change from the operating voltage (e.g., 12V) to a first predetermined voltage (e.g., 9V) lower than the operating voltage. As the DC charger and the vehicle are fully connected, the CC signal CC2 may change from the first predetermined voltage (e.g., 9V) to a second predetermined voltage (e.g., 3V) lower than the first predetermined voltage.

By detecting the voltage of the CC signal CC2 as the second predetermined voltage, the processor may determine that the DC charger and the vehicle are fully connected. In this case, since the DC charger is connected, the CC signal CC1 for the AC charger may maintain the operating voltage 12V. Therefore, the processor may determine to proceed with a DC charging mode among an AC charging mode and the DC charging mode based on the voltages of the CC signals CC1 and CC2. In some embodiments, the processor may check an insulation state of a battery apparatus. In this case, the processor may check the insulation state by periodically cycling turn-on and turn-off of a switch in an insulation circuit. In some embodiments, the processor may check a communication state between the DC charger and a battery management system and/or whether there is a fault in an operation defined for charging before performing DC charging.

The processor may turn on the charge-control switch for DC charging to supply charging current from the DC charger to a battery module of the battery apparatus. In some embodiments, in order to reliably check the insulation state during charging, the processor may set an on/off cycle (measurement cycle) of the switch to be shorter than an on/off cycle (measurement cycle) of the switch before charging

The processor may end the charging procedure after completing the DC charging. To end the charging procedure, the processor may turn off the charge-control switch. In some embodiments, the processor may set the on/off cycle of the switch in the insulation circuit to be longer again. As the DC charging is completed, the DC charger is disconnected from the vehicle so that the CC signal CC2 may increase from 3 V to 9 V and then from 9 V to 12 V. As the DC charger is fully disconnected, the battery management system may enter a sleep state, and the CC signals CC1 and CC2 may change to 0 V.

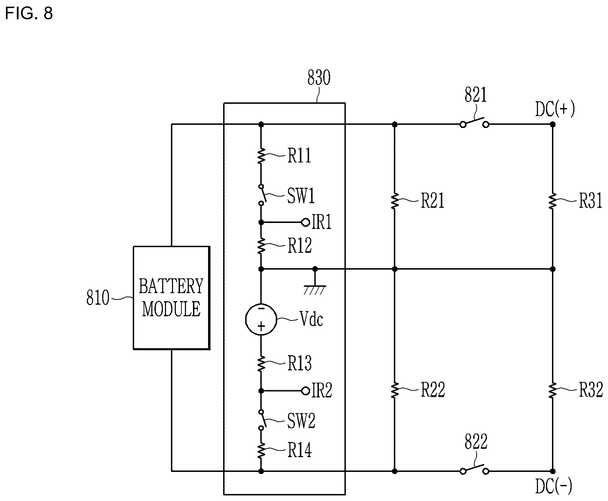

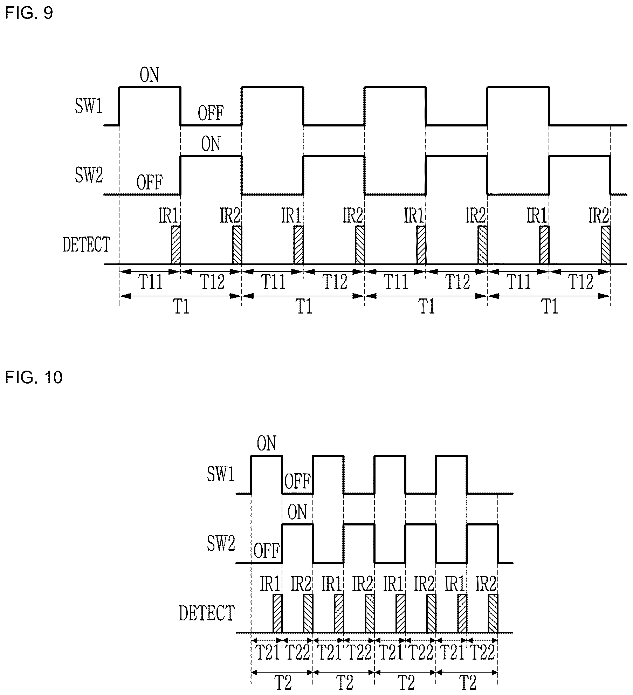

FIG. 8 is a diagram illustrating an example of a battery apparatus according to an embodiment, and FIG. 9 and FIG. 10 are each diagrams illustrating an example of insulation resistance measurement in a battery apparatus according to an embodiment.

Referring to FIG. 8, a battery apparatus 800 may include a battery module 810, switches 821 and 822, and an insulation resistance measurement circuit 830.

In some embodiments, an insulation resistance measurement circuit 830 may include a resistor R11, a switch SW1, and a resistor R12 connected in series between a positive terminal of a battery module 810 and a ground terminal, and a DC voltage source Vdc, a resistor R13, a switch SW2, and a resistor R14 connected in series between the ground terminal and a negative terminal of the battery module 810. The ground terminal may be, for example, a chassis of a vehicle. The insulation resistance measurement circuit 830 may have a first insulation resistance measurement terminal IR1 on a path formed by the resistors R11 and R12 and the switch SW1. When the switch SW1 is turned on, a voltage divided by the resistors R11 and R12 may be measured at the first insulation resistance measurement terminal IR1. For example, a contact of the resistors R11 and R12 may be set to the first insulation resistance measurement terminal IR1. The insulation resistance measurement circuit 830 may have a second insulation resistance measurement terminal TR2 on a path formed by the resistors R13 and R14 and the switch SW2. When the switch SW2 is turned on, a voltage divided by the resistors R13 and R14 may be measured at the second insulation resistance measurement terminal IR2. For example, a contact of the resistors R13 and R14 may be set to the second insulation resistance measurement terminal IR2. In some embodiments, because the resistors R13 and R14 are connected between the negative terminal of the battery module 810 and the ground terminal, the DC voltage source Vdc may be provided so that a voltage at the second insulation resistance measurement terminal IR2 is a positive voltage.

In some embodiments, the insulation resistance measurement circuit 830 may be formed in a region of the battery management system.

In some embodiments, an insulation resistor R21 of the battery apparatus 800 may be formed between the positive terminal of the battery module 810 and the ground terminal, and an insulation resistor R22 of the battery apparatus 800 may be formed between the negative terminal of the battery module 810 and the ground terminal. Further, an insulation resistor R31 of the vehicle may be formed between a positive link terminal DC(+) of the battery module 810 and the ground terminal, and an insulation resistor R32 of the vehicle may be formed between a negative link terminal DC(-) of the battery module 810 and the ground terminal.

The processor (not shown) of the battery apparatus 800 may control operations of the switches SW1 and SW2, and may measure the insulation resistors R21 and R22 based on a voltage of the battery module 810, the voltage at the first insulation resistance measurement terminal IR1, and the voltage at the second insulation resistance measurement terminal IR2. In some embodiments, the battery apparatus 800 may convert the voltages at the first and second insulation resistance measurement terminals IR1 and IR2 into digital signals and transfer the digital signals to the processor.

Referring to FIGS. 8 and 9, in a charge connection phase where a charger is connected and/or a charge ready phase where the charger is ready to charge, the processor may measure an insulation resistance of the battery apparatus 800 in a first measurement period T1.

The processor may turn off the switch SW2 and turn on the switch SW1 during a portion T11 of the first measurement period T1 (e.g., a period corresponding to the first half of the first measurement period). By turning on the switch SW1, a current path through the resistors R11 and R12 may be formed between the positive terminal of the battery module 810 and the ground terminal. Since the insulation resistor R21 is formed between the positive terminal of the battery module 810 and the ground terminal, a circuit in which a set of resistors R11 and R12 and the insulation resistor R21 are connected in parallel may be formed between the positive terminal of the battery module 810 and the ground terminal. Further, a circuit in which the insulation resistor R22 is connected between the ground terminal and the negative terminal of the battery module 810 may be formed. In such a state, the processor may detect the voltage at the first insulation resistance measurement terminal IR1.

Next, the processor may turn off the switch SW1 and turn on the switch SW2 during another portion T12 of the first measurement period T1 (e.g., a period corresponding to the second half of the first measurement period). By turning on the switch SW2, a current path through the voltage source Vdc and the resistors R13 and R14 may be formed between the ground terminal and the negative terminal of battery module 810. Since the insulation resistor R22 is formed between the ground terminal and the negative terminal of the battery module 810, a circuit may be formed in which a set of resistors R13 and R14 and the insulation resistor R22 are connected in parallel between the ground terminal and the negative terminal of the battery module 810. Further, a circuit in which the insulation resistor R21 is connected between the positive terminal of the battery module 810 and the ground terminal may be formed. In such a state, the processor may detect the voltage at the second insulation resistance measurement terminal IR2.

The processor may measure resistances of the insulation resistors R21 and R22 based on the voltage at the first insulation resistance measurement terminal IR1, the voltage at the second insulation resistance measurement terminal IR2, the voltage of the battery module 810, and resistances of the resistors R11, R12, R13, and R14. The processor may measure resistances of the insulation resistors R21 and R22 by repeating the first measurement period T1, and may check breakdown of the insulation resistors R21 and R22 based on the resistances of the insulation resistors R21 and R22 measured in each first measurement period T1 or by comparing the resistances of the insulation resistors R21 and R22 measured in each first measurement period T1.

Referring to FIGS. 8 and 10, in a charging phase where charging begins, the processor may measure the insulation resistance of the battery apparatus 800 in a second measurement period T2 that is shorter than the first measurement period T1.

The processor may detect the voltage at the first insulation resistance measurement terminal IR1 after off turning the switch SW2 and turning on the switch SW1 during a portion T21 of the second measurement period T2 (e.g., a period corresponding to the first half of the second measurement period). Next, the processor may detect the voltage at the second insulation resistance measurement terminal IR2 after turning off the switch SW1 and turning on the switch SW2 during another portion T22 of the second measurement period T2 (e.g., a period corresponding to the second half of the second measurement period).

The processor may measure the resistances of the insulation resistors R21 and R22 based on the voltage at the first insulation resistance measurement terminal IR1, the voltage at the second insulation resistance measurement terminal IR2, the voltage of the battery module 810, and the resistances of the resistors R11, R12, R13, and R14. The processor may measure the resistances of the insulation resistors R21 and R22 by repeating the second measurement period T2, and may check breakdown of the insulation resistors R21 and R22 based on the resistances of the insulation resistors R21 and R22 measured in each second measurement period T2 or by comparing the resistances of the insulation resistors R21 and R22 measured in each second measurement cycle T2.

As described above, the processor may reliably check the breakdown of the insulation resistor during charging of the battery module by setting the insulation resistance measurement period during charging of the battery module to be shorter than the insulation resistance measurement period before charging of the battery module.

While this invention has been described in connection with what is presently considered to be practical embodiments, it is to be understood that the invention is not limited to the disclosed embodiments. On the contrary, it is intended to cover various modifications and equivalent arrangements included within the spirit and scope of the appended claims.

## Claims

1. A battery apparatus configured to be mounted on a vehicle, the battery apparatus comprising:
a battery module; and
a battery management system configured to:
wake up based on a first control signal provided by an alternate current (AC) charger or a direct current (DC) charger in response to a connection between the vehicle and the AC charger or the DC charger,
determine a connection state between the AC charger or the DC charger and the vehicle based on a voltage of a second control signal determined based on the connection between the AC charger and the vehicle, or a voltage of a third control signal determined based on the connection between the DC charger and the vehicle, and
select an AC charging mode or a DC charging mode based on the voltage of the second control signal and the voltage of the third control signal to perform charging.

2. The battery apparatus of claim 1, wherein the second control signal is configured to be changed from a first voltage to a second voltage when the vehicle and the AC charger are not fully connected, and be changed from the second voltage to a third voltage when the vehicle and the AC charger are fully connected, and
wherein the third control signal is configured to maintain the first voltage when the AC charger is connected to the vehicle.

3. The battery apparatus of claim 2, wherein the battery management system is further configured to receive the first control signal from the AC charger via an on-board charger mounted on the vehicle.

4. The battery apparatus of claim 2, wherein the battery management system is further configured to determine whether the AC charger is ready to charge by measuring a pulse width modulation signal provided by the AC charger.

5. The battery apparatus of claim 4, wherein the battery management system is further configured to output a fourth control signal to adjust a voltage level of the pulse width modulation signal during the AC charging.

6. The battery apparatus of claim 1, wherein the third control signal is configured to be changed from a first voltage to a second voltage when the vehicle and the DC charger are not fully connected, and be changed from the second voltage to a third voltage when the vehicle and the DC charger are fully connected, and
wherein the second control signal is configured to maintain the first voltage when the DC charger is connected to the vehicle.

7. The battery apparatus of claim 6, wherein the battery management system is further configured to communicate with the DC charger before performing the DC charging.

8. The battery apparatus of claim 6, wherein the battery management system is further configured to check an insulation state of the battery apparatus before performing the DC charging.

9. The battery apparatus of claim 8, wherein the battery management system is further configured to:
measure an insulation resistance in a first measurement period after the DC charger and the vehicle are connected and before performing charging of the battery module; and
measure the insulation resistance in a second measurement period shorter than the first measurement period during charging of the battery module.

10. The battery apparatus of claim 6, wherein the battery management system is further configured to provide a control signal for controlling a switch to the DC charger for DC charging.

11. The battery apparatus of claim 6, wherein the battery management system is further configured to check an operation of the battery apparatus before performing the DC charging.

12. A battery management system of a battery apparatus configured to be mounted on a vehicle, the battery management system comprising:
a connector configured to be connected to an AC charger or a DC charger, and receive a first control signal provided by the AC charger or the DC charger in response to a connection of the AC charger or the DC charger;
a first control circuit connected to the connector, and configured to determine a voltage of a second control signal based on a connection between the AC charger and the vehicle, and determine a voltage of a third control signal based on a connection between the DC charger and the vehicle; and
a processor configured to wake up the battery management system in response to the first control signal from the connector, determine a connection state between the AC charger or the DC charger and the vehicle based on the voltage of the second control signal or the voltage of the third control signal, and select an AC charging mode or a DC charging mode based on the voltage of the second control signal and the voltage of the third control signal to perform charging.

13. The battery management system of claim 12, wherein the processor is further configured to select the AC charging mode when the voltage of the second control signal is changed and the voltage of the third control signal is maintained.

14. The battery management system of claim 12, wherein the processor is further configured to select the DC charging mode when the voltage of the third control signal is changed and the voltage of the second control signal is maintained.

15. The battery management system of claim 12, wherein the first control circuit comprises:
a first resistor connected between a first output port of the connector from which the second control signal is output and a line for supplying an operating voltage; and
a second resistor connected between a second output port of the connector from which the third control signal is output and a line for supplying the operating voltage.

16. The battery management system of claim 12, further comprising a second control circuit,
wherein the connector is further configured to receive a pulse width modulation signal provided by the AC charger,
wherein the second control circuit comprises a first resistor and a second resistor connected in series between an output port of the connector from which the pulse width modulation signal is output and a ground terminal, and
wherein the processor is further configured to determine whether the AC charger is ready to charge by measuring the pulse width modulation signal based on a voltage at a contact of the first resistor and the second resistor.

17. The battery management system of claim 16, wherein the second control circuit further comprises a switch and a third resistor connected in series between the output port and the ground terminal, and
wherein the processor is further configured to turn on the switch while performing AC charging using the AC charger.

18. The battery management system of claim 12, wherein the processor is further configured to:
measure an insulation resistance in a first measurement period after the DC charger and the vehicle are connected and before performing DC charging, and
measure the insulation resistance in a second measurement period shorter than the first measurement period while performing the DC charging.

19. A method of controlling charging in a battery management system, the method comprising:
receiving a predetermined voltage in response to a connection between a vehicle equipped with the battery management system and a charger;
waking up in response to the predetermined voltage;
selecting an AC charging mode or a DC charging mode based on a voltage of a control signal determined based on the connection between the charger and the vehicle; and
determining a connection state between the charger and the vehicle based on a voltage of the control signal.

20. The method of claim 19, wherein the control signal comprises:
a first control signal whose voltage is changed when an AC charger is connected to the vehicle as the charger; and
a second control signal whose voltage is changed when a DC charger is connected to the vehicle as the charger.
